# EUROPEAN PATENT APPLICATION

(11) **EP 4 765 574 A1**
(43) Date of publication of application: **24.06.2026**
(21) Application number: 25219457.6
(22) Date of filing: 28.11.2025
(51) Int. Cl.: H02J 7/60, G01R 31/396, H01M 10/48, H02J 7/80

(54) **BATTERY ENERGY STORAGE SYSTEM AND A METHOD OF ELECTRICALLY ISOLATING A PLURALITY OF BATTERY CELLS**

(30) Priority: 19.12.2024 US 202418988235
(71) Applicant: Cummins Power Generation Inc., Fridley, MN 55432 (US)
(72) Inventor: Patel, Ankit Vinodchandra, Fridley, 55432 (US)
(74) Representative: Cleveland Scott York

(57) **Abstract**

A battery energy storage system and methods for electrically isolating a plurality of battery cells (106) from an interface port (144) are disclosed. In one example, a method comprises measuring an electrical parameter on a DC bus (132) to which the plurality of battery cells are electrically coupled. An individual battery cell electrical parameter is determined using the electrical parameter and a quantity of the battery cells. Based at least on comparing the individual battery cell electrical parameter to a predefined threshold, the plurality of battery cells (106) are electrically isolated from the interface port (144).

## Description

### BACKGROUND

Energy storage units such as battery energy storage systems utilize multiple battery cells that are selectively charged and discharged.

### SUMMARY

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter. Furthermore, the claimed subject matter is not limited to implementations that solve any or all disadvantages noted in any part of this disclosure.

Examples are disclosed relating to battery energy storage systems and related methods for electrically isolating a plurality of battery cells from an interface port of the system. In one example, a battery energy storage system comprises a plurality of battery cells electrically coupled to a direct current (DC) bus. A power converter is electrically coupled to the DC bus and to an interface port. A switch is located between the plurality of battery cells and the interface port.

A controller comprises memory storing instructions executable to measure an electrical parameter on the DC bus. Using the electrical parameter and a quantity of the battery cells, an individual battery cell electrical parameter is determined. Based at least on comparing the individual battery cell electrical parameter to a predefined threshold, the switch between the plurality of battery cells and the interface port is opened.

In another example, a method of electrically isolating a plurality of battery cells from an interface port of a battery energy storage system comprises measuring an electrical parameter on a direct current bus to which the plurality of battery cells are electrically coupled. An individual battery cell electrical parameter is determined using the electrical parameter and a quantity of the battery cells. Based at least on comparing the individual battery cell electrical parameter to a predefined threshold, the plurality of battery cells are electrically isolated from the interface port.

In another example, a non-transitory machine-readable storage medium comprises instructions that, when executed, cause one or more controllers of a battery energy storage system to measure an electrical parameter on a direct current bus to which a plurality of battery cells of the battery energy storage system are electrically coupled. An individual battery cell electrical parameter is determined using the electrical parameter and a quantity of the battery cells. Based at least on comparing the individual battery cell electrical parameter to a predefined threshold, the plurality of battery cells are electrically isolated from an interface port of the battery energy storage system.

### BRIEF DESCRIPTION OF THE DRAWINGS

FIG. 1 shows one example of a battery energy storage system according to the present disclosure.
FIG. 2 shows another example of a battery energy storage system according to the present disclosure.
FIG. 3 shows another example of a battery energy storage system according to the present disclosure.
FIGS. 4A and 4B are a flow chart of a method of electrically isolating a plurality of battery cells from an interface port of a battery energy storage system according to examples of the present disclosure.
FIG. 5 shows a block diagram of an example computing system according to examples of the present disclosure.

### DETAILED DESCRIPTION

As noted above, battery energy storage systems (BESS) store electrical energy in multiple battery cells that can be discharged to power local or grid-scale energy demands. These battery-held reserves can be switched into grid supply quickly, such as within a few cycles of the alternating current (AC) frequency (50-60 Hz), to satisfy demand or address frequency/voltage instability issues of a grid. In different examples different energy storage technologies can be utilized, including but not limited to Lithium-based systems, flow batteries, lead-acid batteries, sodium-sulfur batteries, and supercapacitors.

In some BESS examples multiple battery cells are integrated into modules. The multiple modules are housed and controlled within a containerized power storage solution. Each module can include a controller for managing individual battery cell charge/discharge functions and monitoring conditions in individual battery cells. For example, a module controller can monitor and control individual battery cell performance to ensure safe operating conditions and efficiency. However, in situations where a module controller is malfunctioning or not responding, proper management of the charge/discharge functions and conditions in individual battery cells can be compromised.

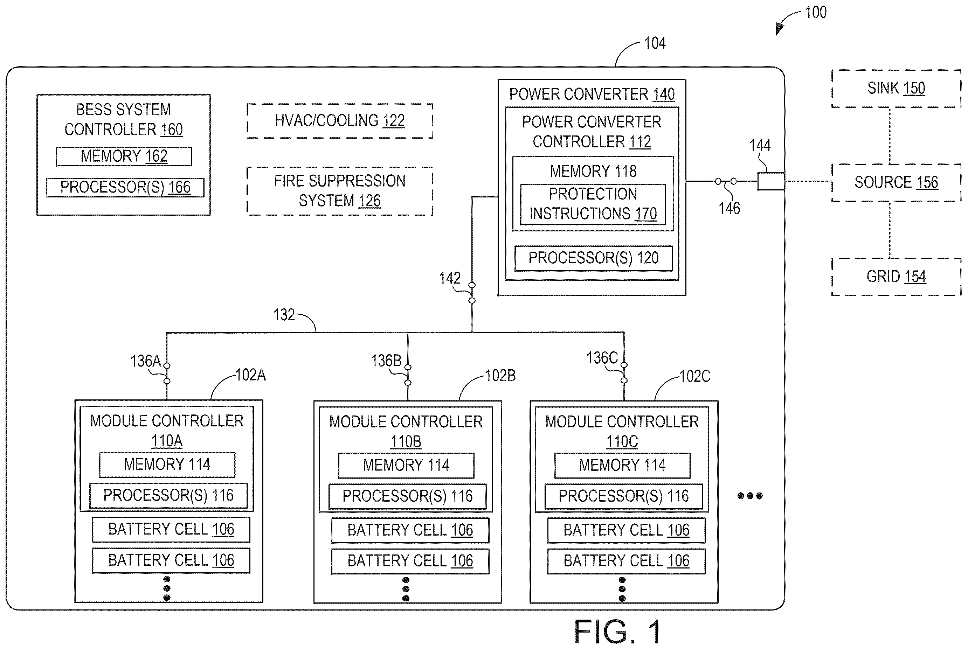

Accordingly, with reference now to FIG. 1 and as described in more detail below, configurations of the present disclosure provide battery energy storage systems and related methods for addressing one or more of the foregoing limitations. In some examples, a BESS of the present disclosure measures an electrical parameter on a direct current (DC) bus to which the plurality of battery cells are electrically coupled. The electrical parameter and a quantity of the battery cells are used to determine an individual battery cell electrical parameter. Based at least on comparing the individual battery cell electrical parameter to a predefined threshold, the plurality of battery cells are electrically isolated from the interface port of the system.

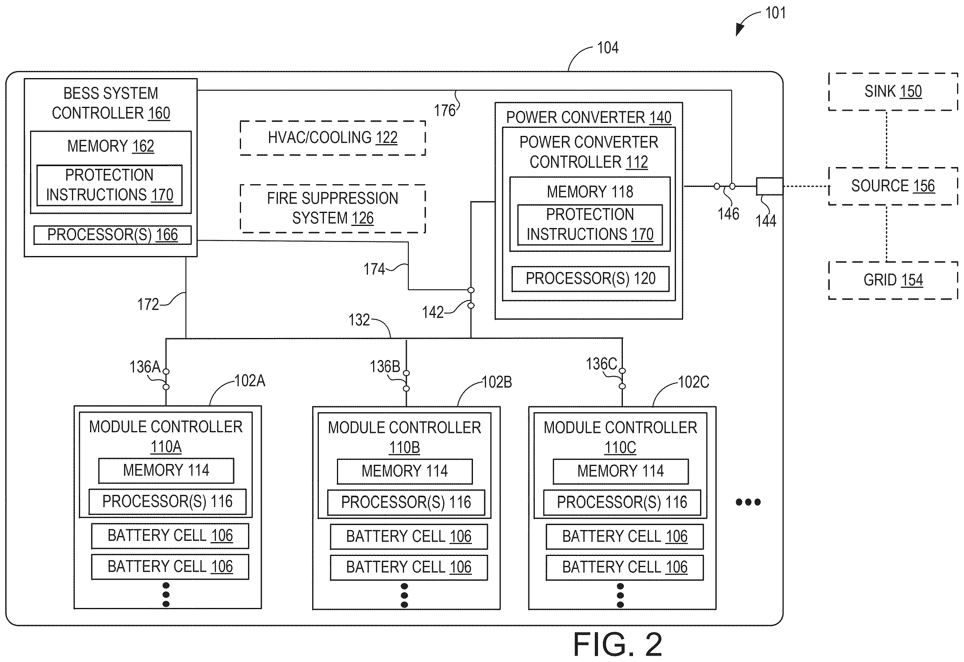

The following examples discuss aspects of the present disclosure in the context of the configurations of FIGS. 1 and 2. In other examples, a variety of other battery energy storage system configurations can be utilized to practice the techniques of the present disclosure.

FIG. 1 schematically illustrates an example battery energy storage system (BESS) 100 according to aspects of the present disclosure. In this example BESS 100 includes a plurality of modules 102 and other components at least partially enclosed within a container 104. As described in more detail below, each of the modules 102 includes a plurality of battery cells 106 coupled in series. In some examples a BESS of the present disclosure can also include an HVAC/cooling system 122, a fire suppression system 126, and/or other components.

In different examples the modules 102 can utilize any quantity of battery cells 106, such as five, ten, 40, 100, or other suitable number of battery cells. The battery cells 106 can utilize any of a variety of different energy storage technologies, including but not limited to Lithium-based systems, flow batteries, lead-acid batteries, sodium-sulfur batteries, and supercapacitors. The battery cells 106 can utilize any suitable construction, including but not limited to cylindrical, prismatic, or pouch construction.

In the present example BESS 100 includes three modules 102A, 102B, and 102C. Each of the modules 102A, 102B, and 102C also includes a corresponding module controller 110A, 110B, 110C that includes memory 114 and one or more processors 116 configured to execute instructions for supervising individual battery cell charge/discharge management, condition monitoring, and cooling monitoring. Other examples of battery energy storage systems of the present disclosure can utilize any quantity of modules 102, such as five, ten, 20, 50, or other suitable number of modules.

In each module 102 the battery cells 106 are electrically coupled to a direct current (DC) bus 132 via a module switch 136, such as a DC contactor, solid state relay, motor operated switch, or solenoid. DC bus 132 is electrically coupled to a power converter 140 via a DC bus switch 142. In the present example power converter 140 comprises an inverter/charger combination that selectively operates as an inverter to convert DC power to AC power and as a rectifier to convert AC power to DC power. In other examples, power converter 140 can be an inverter or a rectifier. The power converter 140 is electrically coupled to an interface port 144 via an AC switch 146.

In the present example the power converter 140 is configured to provide an AC output power signal to a sink device 150 or a utility grid 154, with the AC output power signal being generated from a DC power signal from the DC bus 132. For example, power converter 140 can convert DC power from the battery cells 106 into frequency-synchronized AC power for grid connection or other applications. The power converter 140 is also configured to provide a DC output power signal for charging battery cells 106, where the DC output power signal is generated from an AC power signal received from the utility grid 154 or a source device 156.

In the present example BESS 100 includes a BESS system controller 160 that includes memory 162 (a non-transitory machine-readable storage medium) and one or more processors 166 configured to execute instructions for supervising and monitoring at least some operational aspects of different BESS components, such as the modules 102 and power converter 140. In some examples the BESS system controller 160 is communicatively coupled with one or more external systems or devices. In some examples, BESS 100 is one asset within a local energy system, such as a microgrid, that produces, stores, and distributes energy to facilities coupled to the microgrid. In these examples, BESS system controller 160 is communicatively coupled to one or more microgrid controllers.

As noted above, the module controller 110 in each module 102 manages the charge/discharge functions and monitors conditions in individual battery cells 106 of the module. In some situations, however, a module controller 110 can malfunction or cease responding, thereby adversely affecting management of the individual battery cells 106. Accordingly, in one potential advantage of the present disclosure and as described further below, BESS 100 includes at least one controller that measures one or more electrical parameters on the DC bus 132, utilizes such parameter(s) to identify an event or condition, and in response electrically isolates the battery cells 106 from the interface port 144. In this manner, BESS 100 includes an additional layer of protection that can address situations in which one or more module controllers 110 malfunction or cease responding.

In the example of FIG. 1 and as described further below, memory 118 (a non-transitory machine-readable storage medium) of power converter controller 112 includes protection instructions 170 executable by power converter processor(s) 120 to measure electrical parameter(s) on DC bus 132, use the parameter(s) and a quantity of the battery cells 106 to determine an individual battery cell electrical parameter, and based at least on comparing the individual battery cell electrical parameter to a predefined threshold, electrically isolate the battery cells from the interface port 144, such as by opening the DC bus switch 142. In one example, power converter controller 112 measures a bus voltage on the DC bus 132. Power converter controller 112 also determines the total quantity of the battery cells 106 in modules 102A, 102B, and 102C by accessing a memory of the battery energy storage system 100.

In one example, the total quantity of battery cells 106 is stored in memory 118 of power converter 140. In other examples, the quantity of battery cells 106 is additionally or alternatively stored in memory 162 for BESS system controller 160. In some examples, determining the total quantity of the battery cells 106 includes determining that one or more battery cells are electrically isolated from the direct current bus 132. In these examples, power converter controller 112 is communicatively coupled with each of the module switches 136. In one example where power converter controller 112 determines that module switch 136B is open and module switches 136A and 136C are closed, power converter controller 112 determines that the battery cells 106 of module 102B are electrically isolated from the direct current bus 132 and correspondingly subtracts the quantity of battery cells in module 102B from the total quantity of battery cells used to determine the individual battery cell electrical parameter.

In some examples, power converter controller 112 measures a bus voltage on the DC bus 132, and the individual battery cell electrical parameter is an individual battery cell voltage value. In these examples, power converter controller 112 divides the measured bus voltage by the quantity of the battery cells 106 in BESS 100 to yield an individual battery cell voltage value. Based at least on comparing the individual battery cell voltage value to a predefined threshold, corresponding to a battery cell voltage profile for example, power converter controller 112 electrically isolates the battery cells 106 from the interface port 144, such as by opening the DC bus switch 142.

In one use case example, battery cells 106 take the form of Nickel Manganese Cobalt (NMC) battery cells. When fully charged the individual cell voltage of each battery cell 106 is 4.2V, and when fully discharged the individual cell voltage is 3V. In this example, the total quantity of battery cells 106 is 100. Accordingly, when fully charged the total bus voltage on DC bus 132 would be 420V. When the system is fully discharged the total bus voltage on DC bus 132 would be 300V.

As noted above, power converter controller 112 divides the measured bus voltage by the quantity of the battery cells 106 to yield an individual battery cell voltage value. Power converter controller 112 then compares the individual battery cell voltage value to a predefined threshold, such as a maximum voltage or minimum voltage value. Based at least on comparing the individual battery cell voltage value to the predefined threshold, power converter controller 112 electrically isolates the battery cells 106 from the interface port 144. For example, by comparing the individual battery cell electrical parameter to the predefined threshold, power converter controller 112 can identify an overcharging event, an over-discharging event, or a short circuit in BESS 100.

In one use case example, power converter controller 112 measures a DC bus voltage of 450V during a charging operation. Dividing 450V by 100 (the quantity of battery cells 106) yields an individual cell voltage of 4.5V. As 4.5V is greater than the fully charged voltage 4.2V of an individual cell (the predefined threshold), power converter controller 112 determines that an over-charging event is occurring at one or more of the battery cells 106. Based at least on this determination, the power converter controller 112 electrically isolates the battery cells 106 from the interface port 144, such as by opening the DC bus switch 142, to advantageously prevent further over-charging.

In some examples, power converter controller 112 electrically isolates the battery cells 106 from the interface port 144 by opening the DC bus switch 142 between the DC bus 132 and the power converter 140. In other examples, power converter controller 112 electrically isolates the battery cells 106 from the interface port 144 by opening the AC switch 146 between the power converter 140 and the interface port 144. In some examples, power converter controller 112 electrically isolates the battery cells 106 from the interface port 144 by opening both the DC bus switch 142 and the AC switch 146.

In some examples, power converter controller 112 measures a bus current on the DC bus 132, and the individual battery cell electrical parameter is an individual battery cell current value. In these examples, power converter controller 112 divides the measured bus current by the quantity of the battery cells 106 to yield an individual battery cell current value. Based at least on comparing the individual battery cell current value to a predefined threshold, corresponding to a battery cell current profile for example, power converter controller 112 electrically isolates the battery cells 106 from the interface port 144.

In one use case example where NMC battery cells 106 are utilized and are connected in parallel operation on the DC bus 132, each individual battery cell 106 is rated for 45 amp hours (Ah) at 1C, which is the predefined threshold in this example. In this example, the total quantity of battery cells 106 is 100. Accordingly, during a normal one hour charging operation, the total bus current on DC bus 132 will remain at 4500 A.

In one use case example, power converter controller 112 determines that the total current on DC bus 132 is 4800 A during a one hour charging operation. Dividing 4800 A by 100 (the quantity of battery cells 106) yields an individual cell current of 48 A. As 48 A is greater than the 45 amp hour (Ah) rating for an individual battery cell 106, power converter controller 112 determines that an over-charging event is occurring at one or more of the battery cells 106. Based at least on this determination, the power converter controller 112 electrically isolates the battery cells 106 from the interface port 144.

It will be appreciated that the foregoing are merely use case examples provided for descriptive purposes, and that the principles of the present disclosure also apply to a variety of other use case examples of over-charging, over-discharging, and short circuit events.

In some examples, the BESS system controller 160 also performs the functions of selectively electrically isolating the battery cells 106 from the interface port 144 as described above. With reference now to FIG. 2, in this example of a BESS 101, the BESS system controller 160 includes memory 162 and one or more processors 166 configured to execute instructions for supervising and monitoring at least some operational aspects of different BESS components, such as the modules 102 and power converter 140. Additionally and in this example, memory 162 of BESS system controller 160 also includes the protection instructions 170 that are executable by processor(s) 166 to measure electrical parameter(s) on DC bus 132, such as via sense line 172, use the parameter(s) and a quantity of the battery cells 106 to determine an individual battery cell electrical parameter, and based at least on comparing the individual battery cell electrical parameter to a predefined threshold, electrically isolate the battery cells from the interface port 144 as described above, such as via control lines 174 and/or 176.

Advantageously and in this example, by configuring the BESS system controller 160 with protection instructions 170 in addition to the power converter controller 112, this BESS 101 provides redundant protection of the battery cells 106 in the event that both the module processors 116 and the power converter controller malfunction or otherwise fail to electrically isolate the battery cells from the interface port 144 to address an undesirable event, such as over-charging, over-discharging, or a short circuit.

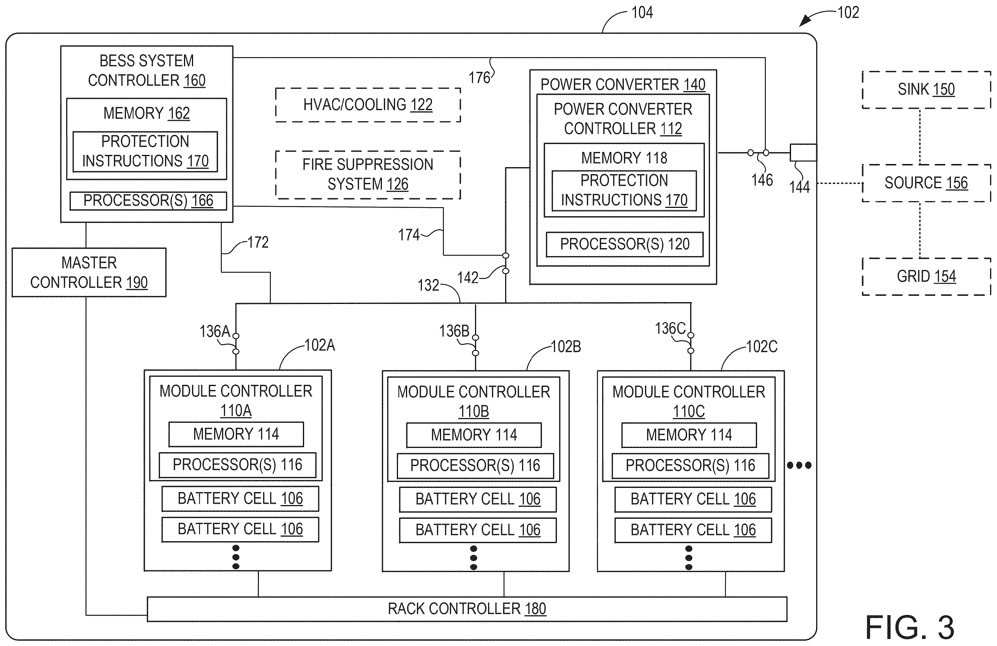

With reference now to FIG. 3, another example of a BESS 102 is provided. In this example BESS 102 includes a rack controller 180 configured to aggregate and manage the operational conditions and states of the individual battery cells 106 in the modules and control the module switches 136 to allow the cells to connect to and disconnect from the DC bus 132. Additionally, in this example rack controller 180 is communicatively coupled with a master controller 190. Master controller 190 is configured to monitor rack controller operations and also manage the operational conditions and states of the individual battery cells 106 in the modules and control the module switches 136. Master controller 190 is communicatively coupled to the BESS system controller 160. Advantageously, in this example the BESS system controller 160 and power converter controller 112 provide further redundant protection for the battery cells 106 in the event that the module processor(s) 116, rack controller 180, and master controller 190 malfunction or otherwise fail to electrically isolate the battery cells from the interface port 144.

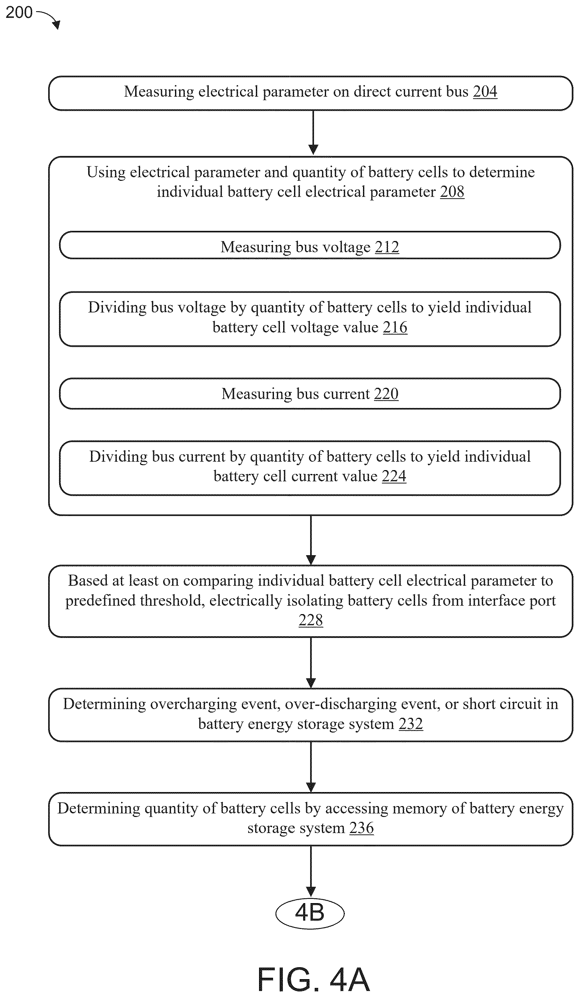

With reference now to FIGS. 4A - 4B, a flow diagram is provided depicting an example method 200 for electrically isolating a plurality of battery cells from an interface port of a battery energy storage system according to examples of the present disclosure. The following description of method 200 is provided with reference to the BESS 100, BESS 101, BESS 102, and related components described herein and shown in FIGS. 1, 2, 3 and 5. In other examples, method 200 is performed with other configurations of BESS systems and computing devices, and in other contexts using other suitable devices and components.

At 204 and with reference also to FIG. 4A, method 200 includes measuring an electrical parameter on a DC bus to which a plurality of battery cells are electrically coupled. At 208 method 200 includes using the electrical parameter and a quantity of the battery cells to determine an individual battery cell electrical parameter. At 212 method 200 includes wherein measuring an electrical parameter on the DC bus comprises measuring a bus voltage on the DC bus, and an individual battery cell electrical parameter is an individual battery cell voltage value. At 216 method 200 includes wherein using the bus voltage and the quantity of the battery cells to determine the individual battery cell voltage value comprises dividing the bus voltage by the quantity of the battery cells to yield the individual battery cell voltage value.

At 220 method 200 includes wherein measuring an electrical parameter on the DC bus comprises measuring a bus current on the DC bus, and the individual battery cell electrical parameter is an individual battery cell current value. At 224 method 200 includes wherein using the bus current and the quantity of the battery cells to determine the individual battery cell current value comprises dividing the bus current by the quantity of the battery cells to yield the individual battery cell current value. At 228 method 200 includes, based at least on comparing the individual battery cell electrical parameter to a predefined threshold, electrically isolating the plurality of battery cells from the interface port.

At 232 method 200 includes wherein comparing the individual battery cell electrical parameter to the predefined threshold comprises determining an overcharging event, an over-discharging event, or a short circuit in the battery energy storage system. At 236 method 200 includes determining the quantity of the battery cells by accessing a memory of the battery energy storage system.

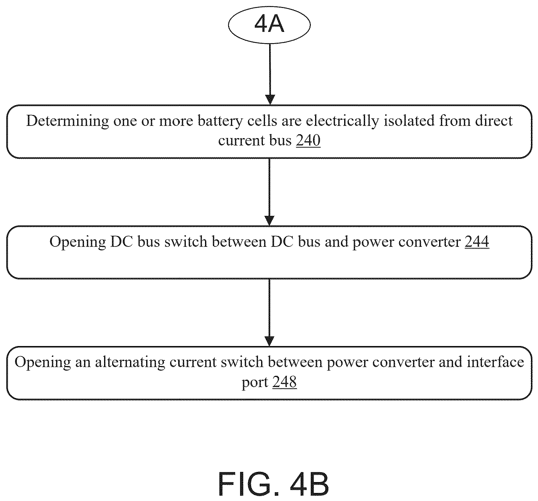

With reference now to FIG. 4B, at 240 method 200 includes wherein determining the quantity of the battery cells comprises determining that one or more battery cells of the plurality of battery cells are electrically isolated from the direct current bus. At 244 method 200 includes wherein electrically isolating the plurality of battery cells from the interface port comprises opening a DC bus switch between the DC bus and a power converter of the battery energy storage system. At 248 method 200 includes wherein electrically isolating the plurality of battery cells from the interface port comprises opening an alternating current (AC) switch between a power converter of the battery energy storage system and the interface port.

In some embodiments, the BESS 100, BESS 101, BESS 102 and components described herein may be utilized with a computing system of one or more computing devices. Similarly, the methods and processes described herein may be implemented as a computer-application program or service, an application-programming interface (API), a library, and/or other computer-program product. Additionally, in some aspects, the steps and/or actions of method 200 may reside as one or any combination or set of codes and/or instructions on a machine readable medium and/or computer readable medium, which may be incorporated into a computer program product.

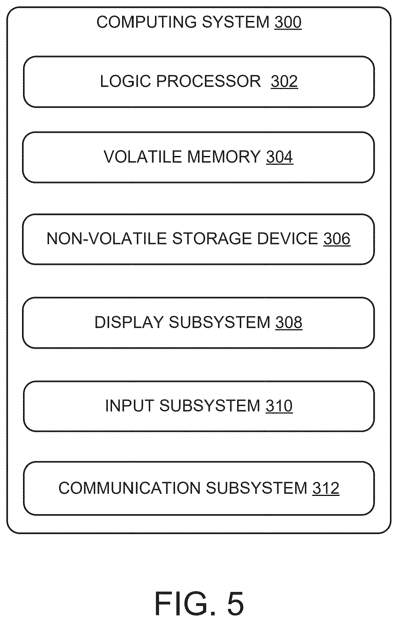

FIG. 5 schematically shows a non-limiting embodiment of a computing system 300 configured to provide any to all of the compute functionality described herein. Computing system 300 is shown in simplified form. The module controllers 110A, 110B, 110C, the power converter controller 112, and the BESS system controller 160 of FIGS. 1, 2, and 3 comprise one or more aspects of the computing system 300. In some examples, computing system 300 may take the form of one or more laptops, personal computers, server computers, tablet computers, home-entertainment computers, gaming devices, mobile computing devices, mobile communication devices (e.g., smart phone), and/or other computing devices.

Computing system 300 includes a logic processor 302, volatile memory 304, and a non-volatile storage device 306. Computing system 300 may optionally include a display subsystem 308, input subsystem 310, communication subsystem 312, and/or other components not shown in FIG. 5.

Logic processor 302 includes one or more physical devices configured to execute instructions, such as the protection instructions 170. For example, the logic processor may be configured to execute instructions that are part of one or more applications, services, programs, routines, libraries, objects, components, data structures, or other logical constructs. Such instructions may be implemented to perform a task, implement a data type, transform the state of one or more components, achieve a technical effect, or otherwise arrive at a desired result.

The logic processor may include one or more physical processors (hardware) configured to execute software instructions. Additionally or alternatively, the logic processor may include one or more hardware logic circuits or firmware devices configured to execute hardware-implemented logic or firmware instructions. Processors of the logic processor 302 may be single-core or multi-core, and the instructions executed thereon may be configured for sequential, parallel, and/or distributed processing. Individual components of the logic processor optionally may be distributed among two or more separate devices, which may be remotely located and/or configured for coordinated processing. Aspects of the logic processor may be virtualized and executed by remotely accessible, networked computing devices configured in a cloud-computing configuration. In such a case, these virtualized aspects are run on different physical logic processors of various different machines, it will be understood.

Volatile memory 304 may include physical devices that include random access memory (RAM). Volatile memory 304 is typically utilized by logic processor 302 to temporarily store information during processing of software instructions. It will be appreciated that volatile memory 304 typically does not continue to store instructions when power is cut to the volatile memory 304.

Non-volatile storage device 306 includes one or more physical devices configured to hold instructions executable by the logic processors to implement the methods and processes described herein. When such methods and processes are implemented, the state of non-volatile storage device 306 may be transformed-e.g., to hold different data.

Non-volatile storage device 306 may include physical devices that are removable and/or built-in. Non-volatile storage device 306 may include optical memory (e.g., CD, DVD, HD-DVD, Blu-Ray Disc, etc.), semiconductor memory (e.g., ROM, EPROM, EEPROM, FLASH memory, etc.), magnetic memory (e.g., hard-disk drive, floppy-disk drive, tape drive, MRAM, etc.), and/or other mass storage device technology. Non-volatile storage device 306 may include nonvolatile, dynamic, static, read/write, read-only, sequential-access, location-addressable, file-addressable, and/or content-addressable devices. It will be appreciated that non-volatile storage device 306 is configured to hold instructions even when power is cut to the non-volatile storage device 306.

Aspects of logic processor 302, volatile memory 304, and non-volatile storage device 306 may be integrated together into one or more hardware-logic components. Such hardware-logic components may include field-programmable gate arrays (FPGAs), program- and application-specific integrated circuits (PASIC / ASICs), program- and application-specific standard products (PSSP / ASSPs), system-on-a-chip (SOC), and complex programmable logic devices (CPLDs), for example.

When included, display subsystem 308 may be used to present a visual representation of data held by non-volatile storage device 306. As the herein described methods and processes change the data held by the non-volatile storage device, and thus transform the state of the non-volatile storage device, the state of display subsystem 308 may likewise be transformed to visually represent changes in the underlying data. Display subsystem 308 may include one or more display devices utilizing virtually any type of technology. Such display devices may be combined with logic processor 302, volatile memory 304, and/or non-volatile storage device 306 in a shared enclosure, or such display devices may be peripheral display devices.

Input subsystem 310 may comprise or interface with one or more user-input devices such as a touchpad, keyboard, touch screen display, a mouse, electronic pen, stylus, or game controller. In some embodiments, the input subsystem may comprise or interface with selected natural user input (NUI) componentry. Such componentry may be integrated or peripheral, and the transduction and/or processing of input actions may be handled on- or off-board. Example NUI componentry may include a microphone for speech and/or voice recognition; an infrared, color, stereoscopic, and/or depth camera for machine vision and/or gesture recognition; a head tracker, eye tracker, accelerometer, and/or gyroscope for motion detection and/or intent recognition; as well as electric-field sensing componentry for assessing brain activity; and/or any other suitable sensor.

When included, communication subsystem 312 may be configured to communicatively couple various computing devices described herein with each other, and with other devices. Communication subsystem 312 may include wired and/or wireless communication devices compatible with one or more different communication protocols. As non-limiting examples, the communication subsystem may be configured for communication via a wireless telephone network, or a wired or wireless local- or wide-area network, such as an HDMI over Wi-Fi connection. In some embodiments, the communication subsystem may allow computing system 300 to send and/or receive messages to and/or from other devices via a network such as the Internet.

The disclosure comprises configurations according to the following examples.

Example 1. A method of electrically isolating a plurality of battery cells from an interface port of a battery energy storage system, the method comprising: measuring an electrical parameter on a direct current bus to which the plurality of battery cells are electrically coupled; using the electrical parameter and a quantity of the battery cells to determine an individual battery cell electrical parameter; and based at least on comparing the individual battery cell electrical parameter to a predefined threshold, electrically isolating the plurality of battery cells from the interface port.

Example 2. The method of example 1, wherein measuring an electrical parameter on the DC bus comprises measuring a bus voltage on the DC bus, and the individual battery cell electrical parameter is an individual battery cell voltage value.

Example 3. The method of example 2, wherein using the bus voltage and the quantity of the battery cells to determine the individual battery cell voltage value comprises dividing the bus voltage by the quantity of the battery cells to yield the individual battery cell voltage value.

Example 4. The method of example 1, wherein measuring an electrical parameter on the DC bus comprises measuring a bus current on the DC bus, and the individual cell electrical parameter is an individual battery cell current value.

Example 5. The method of example 4, wherein using the bus current and the quantity of the battery cells to determine the individual battery cell current value comprises dividing the bus current by the quantity of the battery cells to yield the individual battery cell current value.

Example 6. The method of example 1, wherein comparing the individual battery cell electrical parameter to the predefined threshold comprises determining an overcharging event, an over-discharging event, or a short circuit in the battery energy storage system.

Example 7. The method of example 1, further comprising determining the quantity of the battery cells by accessing a memory of the battery energy storage system.

Example 8. The method of example 1, wherein determining the quantity of the battery cells comprises determining that one or more battery cells of the plurality of battery cells are electrically isolated from the direct current bus.

Example 9. The method of example 1, wherein electrically isolating the plurality of battery cells from the interface port comprises opening a DC bus switch between the DC bus and a power converter of the battery energy storage system.

Example 10. The method of example 1, wherein electrically isolating the plurality of battery cells from the interface port comprises opening an AC switch between a power converter of the battery energy storage system and the interface port.

Example 11. A battery energy storage system, comprising: a plurality of battery cells electrically coupled to a DC bus; a power converter electrically coupled to the DC bus and to an interface port; a switch between the plurality of battery cells and the interface port; and a controller comprising memory storing instructions executable to: measure an electrical parameter on the DC bus; use the electrical parameter and a quantity of the battery cells to determine an individual battery cell electrical parameter; and based at least on comparing the individual battery cell electrical parameter to a predefined threshold, open the switch between the plurality of battery cells and the interface port.

Example 12. The battery energy storage system of example 11, wherein the controller is a power converter controller, the battery energy storage system further comprising a system controller comprising memory storing instructions executable to measure the electrical parameter on the direct current bus; use the electrical parameter and the quantity of the battery cells to determine an individual battery cell electrical parameter; and based at least on comparing the individual battery cell electrical parameter to the predefined threshold, open the switch between the plurality of battery cells and the interface port.

Example 13. The battery energy storage system of example 11, wherein the switch is a DC bus switch between the DC bus and the power converter.

Example 14. The battery energy storage system of example 11, wherein the switch is an alternating current (AC) switch between the power converter and the interface port.

Example 15. The battery energy storage system of example 11, wherein the instructions are executable to measure a bus voltage on the DC bus, and the individual battery cell electrical parameter is an individual battery cell voltage value.

Example 16. The battery energy storage system of example 15, wherein the instructions are executable to determine the individual battery cell voltage value by dividing the bus voltage by the quantity of the battery cells to yield the individual battery cell voltage value.

Example 17. The battery energy storage system of example 11, wherein the instructions are executable to measure a bus current on the DC bus, and the individual battery cell electrical parameter is an individual battery cell current value.

Example 18. The battery energy storage system of example 17, wherein the instructions are executable to determine the individual battery cell current value by dividing the bus current by the quantity of the battery cells to yield the individual battery cell current value.

Example 19. A non-transitory machine-readable storage medium comprising instructions that, when executed, cause one or more controllers of a battery energy storage system to: measure an electrical parameter on a DC bus to which a plurality of battery cells of the battery energy storage system are electrically coupled; use the electrical parameter and a quantity of the battery cells to determine an individual battery cell electrical parameter; and based at least on comparing the individual battery cell electrical parameter to a predefined threshold, electrically isolate the plurality of battery cells from an interface port of the battery energy storage system.

Example 20. The non-transitory machine-readable storage medium of example 19, wherein the instructions, when executed, cause the one or more controllers of the battery energy storage system to electrically isolate the plurality of battery cells from the interface port by opening a switch between the plurality of battery cells and the interface port.

It will be understood that the configurations and/or approaches described herein are exemplary in nature, and that these specific embodiments or examples are not to be considered in a limiting sense, because numerous variations are possible. The specific routines or methods described herein may represent one or more of any number of processing strategies. As such, various acts illustrated and/or described may be performed in the sequence illustrated and/or described, in other sequences, in parallel, or omitted. Likewise, the order of the above-described processes may be changed.

The subject matter of the present disclosure includes all novel and non-obvious combinations and sub-combinations of the various processes, systems and configurations, and other features, functions, acts, and/or properties disclosed herein, as well as any and all equivalents thereof.

## Claims

1. A method of electrically isolating a plurality of battery cells (106) from an interface port (144) of a battery energy storage system (100), the method comprising:
measuring an electrical parameter on a direct current (DC) bus (132) to which the plurality of battery cells are electrically coupled;
using the electrical parameter and a quantity of the battery cells to determine an individual battery cell electrical parameter; and
based at least on comparing the individual battery cell electrical parameter to a predefined threshold, electrically isolating the plurality of battery cells (106) from the interface port (144).

2. The method of claim 1, wherein measuring the electrical parameter on the DC bus comprises measuring a bus voltage on the DC bus, and the individual battery cell electrical parameter is an individual battery cell voltage value.

3. The method of claim 2, wherein using the bus voltage and the quantity of the battery cells to determine the individual battery cell voltage value comprises dividing the bus voltage by the quantity of the battery cells to yield the individual battery cell voltage value.

4. The method of any of the preceding claims, wherein measuring the electrical parameter on the DC bus comprises measuring a bus current on the DC bus, and the individual cell electrical parameter is an individual battery cell current value.

5. The method of claim 4, wherein using the bus current and the quantity of the battery cells to determine the individual battery cell current value comprises dividing the bus current by the quantity of the battery cells to yield the individual battery cell current value.

6. The method of any of the preceding claims, wherein comparing the individual battery cell electrical parameter to the predefined threshold comprises determining an overcharging event, an over-discharging event, and/or a short circuit in the battery energy storage system.

7. The method of any of the preceding claims, further comprising determining the quantity of the battery cells by accessing a memory of the battery energy storage system.

8. The method of claim 7, wherein determining the quantity of the battery cells comprises determining that one or more battery cells of the plurality of battery cells are electrically isolated from the direct current bus.

9. The method of any of the preceding claims, wherein electrically isolating the plurality of battery cells from the interface port comprises opening a DC bus switch between the DC bus and a power converter of the battery energy storage system.

10. The method of any of the preceding claims, wherein electrically isolating the plurality of battery cells from the interface port comprises opening an alternating current (AC) switch between a power converter of the battery energy storage system and the interface port.

11. A battery energy storage system, comprising:
a plurality of battery cells (106) electrically coupled to a direct current (DC) bus (132);
a power converter (140) electrically coupled to the DC bus and to an interface port (144);
a switch (136) between the plurality of battery cells and the interface port; and
a controller (160) comprising memory storing instructions executable to:
measure an electrical parameter on the DC bus (132);
use the electrical parameter and a quantity of the battery cells to determine an individual battery cell electrical parameter; and
based at least on comparing the individual battery cell electrical parameter to a predefined threshold, open the switch (136) between the plurality of battery cells (106) and the interface port (144).

12. The battery energy storage system of claim 11, wherein the controller is a power converter controller, the battery energy storage system further comprising a system controller comprising memory storing instructions executable to:
measure the electrical parameter on the direct current bus (132);
use the electrical parameter and the quantity of the battery cells to determine the individual battery cell electrical parameter; and
based at least on comparing the individual battery cell electrical parameter to the predefined threshold, open the switch (136) between the plurality of battery cells and the interface port.

13. The battery energy storage system of claim 11 or 12, wherein the switch is a DC bus switch between the DC bus and the power converter, and/or wherein the switch is an alternating current (AC) switch between the power converter and the interface port.

14. The battery energy storage system of any of claims 11-13, wherein the instructions are executable to:
measure a bus voltage on the DC bus, wherein the individual battery cell electrical parameter is an individual battery cell voltage value, and optionally to determine the individual battery cell voltage value by dividing the bus voltage by the quantity of the battery cells to yield the individual battery cell voltage value; and/or
measure a bus current on the DC bus, wherein the individual battery cell electrical parameter is an individual battery cell current value, and optionally to determine the individual battery cell current value by dividing the bus current by the quantity of the battery cells to yield the individual battery cell current value.

15. A non-transitory machine-readable storage medium comprising instructions that, when executed, cause one or more controllers of a battery energy storage system to:
measure an electrical parameter on a DC bus (132) to which a plurality of battery cells (106) of the battery energy storage system (100) are electrically coupled;
use the electrical parameter and a quantity of the battery cells to determine an individual battery cell electrical parameter; and
based at least on comparing the individual battery cell electrical parameter to a predefined threshold, electrically isolate the plurality of battery cells (106) from an interface port (144) of the battery energy storage system, optionally by opening a switch (132) between the plurality of battery cells (106) and the interface port (144).
